# DEMANDE DE BREVET EUROPEEN

(11) **EP 2 709 185 A2**
(43) Date de publication de la demande: **19.03.2014**
(21) Numéro de dépôt: 13184447.4
(22) Date de dépôt: 13.09.2013
(51) Int. Cl.: H01L 51/52

(54) **Procédé de fabrication d'une source lumineuse sur support mince pour dispositifs d'éclairage et/ou de signalisation.**

(30) Priorité: 18.09.2012 FR 1258746
(71) Demandeur: VALEO VISION, 93012 Bobigny Cedex (FR)
(72) Inventeur: Brassier, Marc, 94170 LE PERREUX (FR); Zojceski, Zdravko, 92400 COURBEVOIE (FR); Martinez-Perez, Jose Ramon, 23600 MARTOS (ES)

(57) **Abrégé**

L'invention a trait à un procédé de fabrication d'une source de lumière 2 comprenant un support mince 4 pourvu d'une première électrode 8 sur une face principale et extérieure et d'une deuxième électrode 6 sur la face opposée. Le support 4 comprend une série d'orifices traversant la première électrode, chacun de ces orifices étant rempli d'un empilement de couches de matériaux organiques formant une diode électroluminescente organique (OLED). Une couche transparente et conductrice 10 recouvre chacun des orifices. Le champ électrique généré par les électrodes met en mouvement les électrons et les trous dans les couches respectives des diodes de manière à permettre des recombinaisons de paires d'électron et de trou au sein d'une couche émettrice, chacune de ces recombinaisons émettant un photon. Ces mesures permettent la réalisation d'une source lumineuse comprenant une multitude de sources ponctuelles, au moyen d'un support très mince et notamment souple.

## Description

### Domaine technique

L'invention a trait à un procédé de fabrication d'une source lumineuse à diode électroluminescente, plus particulièrement à une source lumineuse comprenant un support avec au moins une diode électroluminescente organique disposée sur le support.

### Technique antérieure

Les diodes électroluminescentes organiques (OLED pour Organic Light-Emitting Diode) sont des composants qui permettent de produire de la lumière. La structure de ces diodes est relativement simple puisqu'elle consiste à superposer plusieurs couches semi-conductrices organiques entre deux électrodes dont l'une (au moins) est transparente.

La technologie OLED est utilisée pour l'affichage dans le domaine des écrans plats et son utilisation comme panneau d'éclairage ou source de lumière pour des dispositifs d'éclairage est une autre application potentielle.

Le document de brevet US 2005/0146870 A1 a trait à un dispositif d'éclairage allongé et flexible, comprenant une série de diodes électroluminescentes notamment du type organique. Le dispositif d'éclairage comprend essentiellement un support mince et flexible avec une série d'électrodes disposées longitudinalement. Des diodes électroluminescentes notamment du type organique sont disposées sur le support entre les électrodes et ensuite connectées à ces électrodes de manière à former une connexion série des diodes. Les diodes peuvent ensuite être encapsulées individuellement ou collectivement par des enveloppes transparentes, semi-transparentes ou colorées. Ce dispositif d'éclairage semble être prévu essentiellement pour un usage décoratif. En effet, il est particulièrement allongé à la manière d'une guirlande éclairante. Les différentes diodes sont d'ailleurs espacées les unes des autres. Le dispositif décrit n'est donc pas adapté à servir de source lumineuse ponctuelle ou du moins compacte pour un dispositif d'éclairage et/ou de signalisation notamment pour véhicule.

Les documents de brevet EP 1 377 133 A1 et US 2002/041149 A1 proposent une source lumineuse palliant au moins un des inconvénients sus mentionnés. Plus particulièrement, la source lumineuse est compacte, et est susceptible d'offrir une puissance d'éclairage satisfaisante, apte à être disposée dans un boîtier de dispositif d'éclairage et/ou de signalisation notamment d'un véhicule.

Ces documents de brevet EP 1 377 133 A1 et US 2002/041149 A1 décrivent une source lumineuse comprenant un support avec au moins deux électrodes distinctes sur le support; au moins une diode électroluminescente organique sur le support alimentée par les au moins deux électrodes; remarquable en ce que une première des au moins deux électrodes est disposée sur une première face du support et une deuxième des au moins deux électrodes est disposée sur une deuxième face du support, opposée à la première face, les première et deuxième électrodes se chevauchant sur une portion du support; la portion du support comprend au moins un orifice, la diode électroluminescente organique étant logée dans l'orifice ou dans au moins un des orifices.

### Résumé de l'invention :

L'invention a pour objet de proposer un procédé de fabrication d'une telle source lumineuse, comprenant un support avec au moins deux électrodes distinctes sur le support, et au moins une diode électroluminescente organique sur le support, alimentée par les au moins deux électrodes, dans laquelle source lumineuse une première des au moins deux électrodes est disposée sur une première face du support et une deuxième des au moins deux électrodes est disposée sur une deuxième face du support, opposée à la première face, les première et deuxième électrodes se chevauchant sur une portion du support; ladite portion du support comprend au moins un orifice, la diode électroluminescente organique étant logée dans l'orifice ou dans au moins un des orifices.

Ce procédé est remarquable par les étapes suivantes: (a) réalisation du support par moulage, avec une première des au moins deux électrodes sur une première face du support et d'une deuxième des au moins deux électrodes sur une deuxième face du support, les première et deuxième électrodes se chevauchant sur une portion du support, et avec au moins un orifice dans ladite portion de support; (b) dépôt de couches organiques dans l'orifice ou dans au moins un des orifices de manière à y former la diode électroluminescente organique.

Les couches organiques peuvent être appliquées par dépôt sous vide et/ou par impression à jet.

Selon un mode avantageux de l'invention, la réalisation de l'orifice ou d'au moins un des orifices a lieu par moulage ou étirage/laminage lors de la réalisation du support à l'étape (a) et/ou par enlèvement de matière après ladite opération de moulage ou étirage/laminage à l'étape (a). L'enlèvement de matière peut être réalisé par application d'un rayon laser.

Selon un autre mode avantageux de l'invention, l'étape (b) comprend le dépôt d'au moins une couche organique de transport de trous HTL, au moins une couche d'émission EML et au moins une couche de transport d'électrons ETL.

### Descriptif des figues :

D'autres caractéristiques et avantages de la présente invention seront mieux compris à l'aide de la description et des dessins parmi lesquels :
   - la figure 1 est une vue en coupe d'une source de lumière obtenue par le procédé selon l'invention ;
   - la figure 2 est une vue agrandie d'un orifice de la source de lumière de la figure 1, illustrant la répartition de lignes du champ électrique le traversant ;
   - la figure 3 est une vue en perspective d'une source de lumière obtenue par le procédé selon l'invention.

### Description détaillée

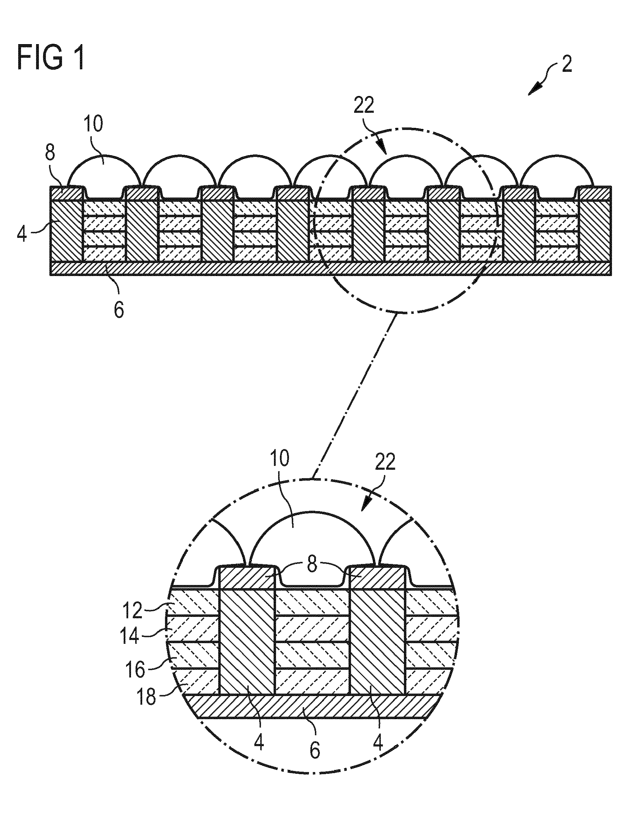

La figure 1 est une vue en coupe d'une source de lumière 2 comprenant essentiellement un support mince 4 pourvu d'une série de trous ou orifices logeant, chacun, un empilement de couches organiques formant la diode électroluminescente organique 22.

Le support 4 comprend une première électrode 8 disposée sur une première face supérieure ou visible du support, et une deuxième électrode 6 disposée sur une deuxième face inférieure ou non visible du support. La première face est opposée à la deuxième. La première électrode 8 chevauche la deuxième électrode 6 sur au moins une portion du support. Dans le cas précis de l'exemple de la figure 1, le chevauchement a lieu sur toute la largeur du support. La première électrode 8 comporte une série d'ouvertures en regard des orifices du support de manière à laisser un accès total aux orifices notamment lors de la déposition des couches organiques.

La première électrode 8 est destinée à être mise à un potentiel électrique donné et la deuxième électrode 6 est destinée à être mise à un potentiel électrique inférieur au potentiel électrique de la première électrode. La première électrode est par conséquent appelée anode, et la deuxième électrode 6 est appelée cathode.

La structure de base des diodes électroluminescentes organiques (OLED) consiste à superposer plusieurs couches de matériaux organiques entre la cathode et l'anode. Les couches minces organiques comportent typiquement une couche de transport de trous (HTL pour « Hole Transport Layer »), une couche d'émission (EML pour « Emission Layer ») et une couche de transport d'électrons (ETL pour « Electron Transport Layer »). En appliquant une tension électrique appropriée, les électrons et les trous sont injectés dans la couche EML à partir de la cathode et de l'anode. Les électrons et les trous se combinent dans la couche EML pour former des excitons puis l'électroluminescence apparaît. Le principe de fonctionnement des OLED est basé sur l'électroluminescence. La source de lumière est en fait due à la recombinaison d'un exciton (paire électron-trou), à l'intérieur de la couche émettrice. Lors de cette recombinaison, un photon est émis.

Les couches organiques sont désignées par les références 12, 14, 16, et 18 à la figure 1. Cette dernière représente quatre couches, sachant que le nombre de couches peut varier et est en principe supérieur ou égal à trois.

Une couche transparente 10 est également prévue au dessus de l'empilement de couches organiques 12, 14, 16 et 18. Cette couche encapsule l'empilement de couches organiques au sein de l'orifice du support 4. Cette couche peut être à base de silicone et/ou comprendre des oxydes métalliques tels que des oxydes d'indium-étain.

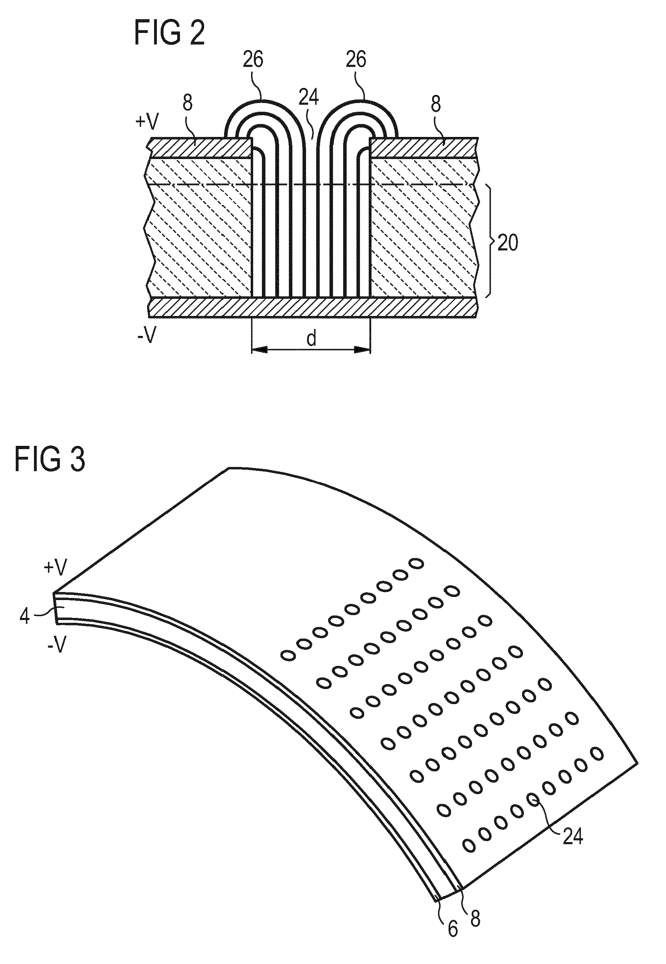

La figure 2 illustre le principe de fonctionnement de la diode électroluminescente organique 22 disposée dans un orifice du support 4. L'application d'une différence de potentiel aux électrodes 8 et 6 va générer un champ électrique représenté par les lignes de champ 26. Comme on peut le constater à la figure 2, le champ électrique est perturbé à hauteur de l'ouverture de la première électrode 8, alors qu'il s'uniformise progressivement au fur et à mesure que l'on pénètre dans l'orifice 24. La zone quasi uniforme est représentée par le signe 20 à la figure 2. Cette zone correspond essentiellement au 2/3 ou 3/4 de la profondeur de l'orifice 24. L'uniformité du champ électrique est intéressante afin d'assurer une utilisation optimale de la diode logée dans l'orifice 24. En effet, il est important que la majorité de la section de l'empilement de couches organiques soit soumise au champ électrique afin de générer un maximum d'électrons et de trous dans les couches de transport d'obtenir un maximum de recombinaisons de paires électron-trou et, partant, un maximum d'émission de lumière.

L'uniformité du champ électrique est essentiellement liée au rapport entre l'épaisseur du support et le diamètre moyen d de l'orifice. En effet, compte tenu du fait que la majorité des lignes de champ partent de la surface principale (par opposition à la tranche de l'électrode au bord de l'orifice) de la première électrode (ou encore anode), ces lignes de champ doivent opérer un changement d'orientation depuis la surface en question jusqu'à l'intérieur de l'orifice, ce changement d'orientation étant de l'ordre de 120°-150°. Ce changement d'orientation est à l'origine du manque d'uniformité du champ électrique à l'entrée de l'orifice, comme cela est illustré à la figure 2. En effet, à la figure 2 on peut observer un « trou » dans le champ électrique au centre de l'orifice à une hauteur au dessus du trait interrompu référencé 20, cette hauteur correspondant à l'entrée de l'orifice. Plus l'orifice sera de grand diamètre, plus la distance nécessaire aux lignes de champ pour se rejoindre au centre de l'orifice sera longue. Dans ce cas, il sera nécessaire d'avoir une épaisseur de support suffisance pour que cette distance ne représente qu'une fraction de la profondeur de l'orifice. En pratique, les essais et mesures ont montré qu'une épaisseur de support (correspondant à la profondeur de l'orifice) proche du diamètre moyen d de l'orifice permet d'atteindre une homogénéité satisfaisante du champ électrique dés une distance depuis l'ouverture de l'orifice qui correspond à un quart de la profondeur. En d'autres termes, les trois-quarts de la profondeur de l'orifice (en partant du fond) sont disponibles pour générer les phénomènes électriques désirés dans les couches organiques de la diode électroluminescente. La profondeur de l'orifice correspond préférentiellement au diamètre moyen de l'orifice dans une tolérance de 50%, plus préférentiellement de 30%, plus préférentiellement encore de 20%.

L'utilisation d'un orifice de plus grand diamètre nécessite par conséquent une profondeur d'orifice plus importante. Or le champ électrique en un point donné étant proportionnel à l'inverse du carré de la distance entre ce point et la charge électrique, il s'ensuit qu'un orifice de plus grand diamètre va nécessiter une différence de potentiel aux électrodes plus importante. Afin de pouvoir travailler avec des différences de potentiel de l'ordre de quelques volts, la profondeur de l'orifice, et donc l'épaisseur du support est préférentiellement inférieure à 200 µm. Le diamètre moyen de l'ouverture sera alors préférentiellement également inférieur à 200 µm. De manière plus préférentiellement, l'épaisseur du support et/ou le diamètre moyen de l'ouverture sont inférieurs à 100 µm.

Concernant la figure 2, le champ électrique dans un cas particulier pourra être modifié par la ou les couches organiques de transport de trous HTL et la ou les couches de transport d'électrons ETL, en fonction de leurs propriétés physiques. L'épaisseur relative de ces couches sera choisie afin d'optimiser aussi bien le transport des porteurs de charge, que l'extraction de la lumière crée dans la ou les couches d'émission EML. Ainsi, des configurations dans lesquelles une partie des parois d'orifice sont métallisés ou couvertes de matière HTL ou ETL sont envisageables.

La figure 3 illustre la source lumineuse 2 dans sa totalité dans un état où les orifices ne sont pas encore remplis des couches organiques formant les diodes électroluminescentes. Elle présente une forme généralement courbée. Son support 4 présente un profil généralement droit dans une section transversale et un profil généralement courbe dans une section longitudinale. Cette configuration est à titre d'exemple et d'autres configurations planes et non planes sont possibles. On peut observer l'anode 8 et la cathode 6 sur les faces principales respectives du support 4.

Dans un premier temps du procédé, le support 4 est réalisé par moulage ou par étirement/laminage, avec une première 8 des au moins deux électrodes 6, 8 sur une première face du support 4 et d'une deuxième 6 des au moins deux électrodes 6, 8 sur une deuxième face du support 4, les première et deuxième électrodes 8, 6 se chevauchant sur une portion du support 4, et avec au moins un orifice 24 dans ladite portion de support.

En référence à la figure 3, une série d'orifices 24 sont formés dans le support 4. Selon l'invention, la réalisation de l'orifice 24 ou d'au moins un des orifices 24 a lieu par moulage ou étirage/lamination lors de la réalisation du support 4 à l'étape précédente. Alternativement ou cumulativement, elle peut être réalisée par enlèvement de matière après ladite opération de moulage ou étirage/lamination du support 4 de l'étape précédente. Les orifices ou creux 24 peuvent être formés au moyen d'un laser.

Dans un second temps du procédé, on réalise le dépôt de couches organiques 12, 14, 16, 18 dans l'orifice 24 ou dans au moins un des orifices 24 de manière à y former la diode électroluminescente organique 22.

Selon une variante préférée, cette étape de dépôt comprend le dépôt d'au moins une couche organique de transport de trous HTL 12, au moins une couche d'émission EML 14 et au moins une couche de transport d'électrons ETL 16.

Les couches de matériaux organiques formant les diodes peuvent être déposées sur le support par des méthodes de dépôt bien connues en soi de l'homme de métier. Parmi ces méthodes, on compte notamment le dépôt sous vide ainsi qu'une méthode d'impression à jet. Cette dernière présente l'avantage de ne pas nécessiter l'utilisation d'un masque et d'optimiser l'utilisation des matières premières des couches organiques.

La source de lumière obtenue par le procédé selon l'invention peut ainsi comprendre un très grand nombre de diodes électroluminescentes organiques, et, partant, atteindre une puissance d'éclairage importante. Les diodes peuvent être disposées librement sur le support afin d'obtenir une répartition de sources d'éclairage correspondant aux besoins d'une application particulière. Le support, de par sa minceur, peut être flexible. Il peut en effet être du type circuit imprimé flexible couramment utilisé dans les applications électroniques. Ce type de support peut être fabriqué à partir de matériaux tels que du polyester, un polyéthylène téréphtalate (PET) qui présente de meilleures propriétés d'auto-cicatrisation, ou encore un polynaphtalate d'éthylène (PEN) qui a de meilleures caractéristiques en température, ou du polyimide (Pl) qui a de meilleures caractéristiques mécaniques. Le support peut également être fabriqué à partir d'un polyphénylène sulfide (PPS), d'un polycarbonate (PC) ou d'un polytétrafluoroéthylène (PTFE). Toutes ces possibilités confèrent une grande liberté de mise en oeuvre de la source lumineuse au sein d'un dispositif d'éclairage et/ou de signalisation.

## Revendications

1. Procédé de fabrication d'une source lumineuse (2) comprenant un support (4) avec au moins deux électrodes distinctes (6, 8) sur le support (4), et au moins une diode électroluminescente organique (22) sur le support (4), alimentée par les au moins deux électrodes (6, 8) ;
**caractérisé par** les étapes suivantes :
(a) réalisation du support (4) par moulage ou par étirement/laminage, avec une première (8) des au moins deux électrodes (6, 8) sur une première face du support (4) et d'une deuxième (6) des au moins deux électrodes (6, 8) sur une deuxième face du support (4), les première et deuxième électrodes (8, 6) se chevauchant sur une portion du support (4), et avec au moins un orifice (24) dans ladite portion de support ;
(b) dépôt de couches organiques (12, 14, 16, 18) dans l'orifice (24) ou dans au moins un des orifices (24) de manière à y former la diode électroluminescente organique (22).

2. Procédé selon la revendication 1, **caractérisé en ce que** la réalisation de l'orifice (24) ou d'au moins un des orifices (24) a lieu par moulage ou étirage/lamination lors de la réalisation du support (4) à l'étape (a) et/ou par enlèvement de matière après ladite opération de moulage ou étirage/lamination du support (4) de l'étape (a).

3. Procédé selon l'une des revendications 1 ou 2, **caractérisé en ce que** l'étape (b) comprend le dépôt d'au moins une couche organique de transport de trous HTL (12), au moins une couche d'émission EML (14) et au moins une couche de transport d'électrons ETL (16).
